# EUROPEAN PATENT APPLICATION

(11) **EP 4 559 868 A1**
(43) Date of publication of application: **28.05.2025**
(21) Application number: 23211858.8
(22) Date of filing: 23.11.2023
(51) Int. Cl.: B81B 3/00

(54) **MEMS DEVICE AND METHOD FOR MANUFACTURING THE MEMS DEVICE**

(71) Applicant: OQmented GmbH, 25524 Itzehoe (DE)
(72) Inventor: HOFMANN, Ulrich, 25524 Itzehoe (DE); VON WANTOCH, Thomas, 24159 Kiel (DE); GAUDET, Matthieu, 24235 Wendtorf (DE)
(74) Representative: LeoBlu Patentanwälte Rolinec Winter PartG mbB

(57) **Abstract**

The present disclosure relates to a MEMS device 1100 - 1300 and a method for manufacturing the MEMS device 1100 -1300, the MEMS device 1100 -1300 comprises a device layer 3 comprising spring sections 3a and a function element 3b being spring-mounted by the spring sections 3a, wherein the function element 3b is configured to be driven to oscillate along and/or about at least one oscillation axis X, Y, and at least one piezo damper 8 provided at the function element 3b and configured to damp alternating elastic deformations of the function element 3b resulting from the oscillation.

## Description

The present disclosure relates to a MEMS device and to a method for manufacturing the MEMS device, especially a MEMS micromirror device.

### Background

MEMS devices typically operate in 1D or 2D oscillating manner, wherein a function element (for example a micromirror or a support element) of a device layer of the MEMS device can be oscillated near the resonant frequencies of the oscillating parts of the device layer to reduce the input of energy necessary to drive the oscillating parts of the device layer.

However, above a specific level of oscillation frequency of the function element of the device layer, for example above 1/10 of the resonant frequency, which could be seen as out of the quasi-static regime, the inertia of the function element tends to elastic deformation of the function element that can have a significant influence of the performance of the MEMS device for its respective application (for example, when used as micromirror device, degrading the planarity of the mirror surface and, thereby, the quality of the reflected laser beam, especially the pattern of the laser spot projected via a reflection on the micromirror and the projected image, but also when used as sensor etc.) with rising oscillation frequencies.

It is therefore an important object to avoid or at least to reduce deformations of the function element when oscillating and the respective negative influences as described above.

Various solutions to avoid deformations of the function element of MEMS devices are known, like stiffening the structure of the device layer or reducing the moment of inertia of the respective oscillating parts, for example by mass reduction.

However, to stiffen the structure of the device layer, e.g. the function element, often means that additional material / mass of material is applied to achieve the stiffening, which leads to a higher mass of the oscillating parts. But this is in opposition to the desire to reduce the moment of inertia of the function element.

Moreover, since the manufacturing of MEMS devices are evolved from the process technology in semiconductor device fabrication, for example deposition of material layers, patterning by photolithography and etching to produce the required shapes, the options for applying deformation compensating solutions is limited to be applicable by said semiconductor device fabrication techniques.

In view of the above, it is an object of the present disclosure to provide a MEMS device and a method for manufacturing such one improving on the above drawbacks.

### Summary

For solving the above object, there is proposed a MEMS device, especially a MEMS micromirror device, according to claim 1. Furthermore, a method for manufacturing the MEMS device according to claim 13 is proposed.

Dependent claims relate to some exemplary embodiments.

According to a first aspect, there is proposed a MEMS device, especially a MEMS micromirror device.

According to a second aspect, there is proposed a method for manufacturing the MEMS device.

In some exemplary aspects, the MEMS device comprises a device layer comprising spring sections and a function element being spring-mounted by the spring sections, wherein the function element is configured to be driven to oscillate along and/or about at least one oscillation axis, and at least one piezo damper provided at the function element and configured to damp alternating elastic deformations of the function element resulting from the oscillation.

In some exemplary aspects of the MEMS device, the at least one piezo damper is provided at predetermined locations of alternating elastic deformations of the function element.

In some exemplary aspects of the MEMS device, the at least one piezo damper is configured to damp the alternating elastic deformations of the function element by transforming the mechanical energy of the alternating elastic deformations to electrical energy or by generating mechanical force acting against the alternating elastic deformations based on provided electrical energy.

In some exemplary aspects of the MEMS device, the at least one piezo damper is electrically connected with an electronic circuit configured to transform the electrical energy generated by the at least one piezo damper to another energy type or to provide electrical energy to the at least one piezo damper for generating mechanical force acting against the alternating elastic deformations.

In some exemplary aspects of the MEMS device, the at least one piezo damper is formed by a pair of piezo elements being electrically connected with each other via an electronic circuit configured to transform the electrical energy generated by the pair of piezo elements to another energy type or to provide electrical energy to each piezo element of the respective pair of piezo elements for generating mechanical force acting against the alternating elastic deformations.

In some exemplary aspects of the MEMS device, the at least one piezo damper is provided at predetermined locations of the function element adjacent to at least one region of non-deflection from an average plane of the function element.

In some exemplary aspects of the MEMS device, one piezo element of the pair of piezo elements is provided at the function element at a side of the at least one region of non-deflection from the average plane of the function element and the other one piezo element of the pair of piezo elements is provided at the function element at the other side of the at least one region of non-deflection from the average plane of the function element, wherein one pair of piezo elements corresponds to one region of non-deflection from the average plane of the function element.

In some exemplary aspects of the MEMS device, the piezo elements of the pair of piezo elements of the at least one piezo damper are provided at the function element symmetrically to the at least one region of non-deflection from the average plane of the function element.

In some exemplary aspects of the MEMS device, one piezo element of the pair of piezo elements is provided at the function element at a predetermined location of convex shape or concave shape of a surface of the function element corresponding to the alternating elastic deformations and the other one piezo element of the pair of piezo elements is provided at the function element at a predetermined location of the respective other shape of a surface of the function element, wherein the convex shape and the concave shape occur at the same time.

In some exemplary aspects of the MEMS device, the function element comprises at least one pair of mounting points of the spring sections being mounted with the function element, wherein the at least one piezo damper is provided adjacent to an imaginary straight line between the mounting points of the at least one pair of mounting points.

In some exemplary aspects of the MEMS device, one piezo element of the pair of piezo elements is provided at the function element at a side of the imaginary straight line and the other one piezo element of the pair of piezo elements is provided at the function element at the other side of the imaginary straight line, wherein one pair of piezo elements corresponds to a single imaginary straight line.

In some exemplary aspects of the MEMS device, the piezo elements of the pair of piezo elements of the at least one piezo damper are provided at the function element symmetrically to the imaginary straight line of the at least one pair of mounting points.

In some exemplary aspects of the MEMS device, the piezo elements of the pair of piezo elements of the at least one piezo damper are provided at the function element symmetrically to the at least one region of non-deflection from the average plane of the function element and to the imaginary straight line of the at least one pair of mounting points.

In some exemplary aspects, the MEMS device further comprises at least two piezo dampers formed by a pair of piezo elements each, wherein the piezo elements of the respective pair of piezo elements are electrically connected with each other via an electronic circuit configured to transform the electrical energy generated by the respective pair of piezo elements to another energy type or to provide electrical energy to each piezo element of the respective pair of piezo elements for generating mechanical force acting against the alternating elastic deformations, wherein the function element is configured to oscillate about two oscillation axes, in particular to oscillate in two or more transverse normal modes, and wherein the piezo elements of the at least two pairs of piezo elements are provided at the function element symmetrically to the two oscillation axes.

In some exemplary aspects of the MEMS device, the piezo elements are provided at the same side of the function element.

In some exemplary aspects, the MEMS device further comprises at least one actuator configured to drive the function element to oscillate along and/or about the at least one oscillation axis, wherein the at least one actuator is provided at the device layer, wherein the at least one piezo damper is provided at a side of the function element of the device layer which is the same side of the device layer at which the at least one actuator is provided, or the at least one piezo damper is provided at a side of the function element of the device layer which is opposite to a side of the device layer at which the at least one actuator is provided.

In some exemplary aspects, the MEMS device further comprises a function surface that is provided at the function element, wherein the at least one piezo damper is provided between the function surface and the function element, or the at least one piezo damper is provided at a side of the function element that is opposite to a side of the function element at which the function surface is provided.

In some exemplary aspects, the MEMS device further comprises a function surface provided at the function element, wherein the at least one piezo damper is provided at a side of the function element at which the function surface is provided.

In some exemplary aspects of the MEMS device, the function surface comprises a mirror configured to reflect incident electromagnetic radiation, in particular an incident laser beam.

In some exemplary aspects of the MEMS device, the electronic circuit comprises at least one of resistance, capacitance and/or inductance.

In some exemplary aspects of the MEMS device, the electronic circuit is a resonant circuit.

In some exemplary aspects of the MEMS device, the resonant circuit has a circuit frequency that is aligned with the oscillation frequency of the function element.

In some exemplary aspects of the MEMS device, the electronic circuit is provided at the function element.

In some exemplary aspects of the MEMS device, the electronic circuit is provided at a side of the function element at which the at least one piezo damper is provided, or the electronic circuit is provided at a side of the function element that is opposite to a side of the function element at which the at least one piezo damper is provided.

In some exemplary aspects of the method for manufacturing the MEMS device, the method can comprise: providing a base element for building the device layer comprising spring sections and a function element being spring-mounted by the spring sections; applying a layer of piezo material at least on a section of the base element which will be the function element of the device layer, wherein the piezo material is applied on the base element such that alternating elastic deformations of the function element cause a piezo electric effect of the piezo material; structuring the layer of piezo material to form the at least one piezo damper; and structuring the base element to form the spring sections and the function element of the device layer, wherein the at least one piezo damper is provided at the function element.

In some exemplary aspects of the method for manufacturing the MEMS device, the method can further comprise: determining locations of alternating elastic deformations of the function element resulting from an oscillation of the function element along and/or about at least one oscillation axis of the MEMS device, in particular from an oscillation of the function element in at least one transverse normal mode, wherein the piezo material is structured to form the at least one piezo damper at the function element at the respective determined locations of alternating elastic deformations of the function element.

In some exemplary aspects of the method for manufacturing the MEMS device, structuring the layer of piezo material comprises the forming of the at least one piezo damper and the at least one actuator configured to drive the function element to oscillate along and/or about the at least one oscillation axis, in particular to drive the function element to oscillate in at least one transverse normal mode.

In some exemplary aspects of the method for manufacturing the MEMS device, the method can further comprise: applying a conductive layer for building the electronic circuit; and structuring the applied conductive layer to form the electronic circuit electrically connected with the at least one piezo damper.

In some exemplary aspects of the method for manufacturing the MEMS device, structuring the applied conductive layer comprises forming of at least one of resistance, capacitance and/or inductance.

In some exemplary aspects of the method for manufacturing the MEMS device, the method can further comprise: forming a function surface on the function element, wherein the at least one piezo damper is provided between the function surface and the function element, or the at least one piezo damper is provided at a side of the function element which is opposite to a side of the function element at which the function surface is provided.

In some exemplary aspects of the method for manufacturing the MEMS device, the function surface is a mirror configured to reflect incident electromagnetic radiation.

### Brief Description of Drawings

**Fig. 1** is a schematic illustrative view of exemplary elastic deformations of the function element occurring during oscillation of the function element;
**Fig. 2** is a schematic illustrative view of an exemplary deformed function element with a piezo damper formed by a pair of piezo elements for damping the elastic deformations of the function element;
**Fig. 3** is (a) a schematic illustrative view of a function element exemplary deformed during rotational oscillation, which comprises two piezo dampers formed by a pair of piezo elements each for damping the elastic deformations of the function element, and (b) a schematic illustrative view of a function element exemplary deformed during translatory oscillation, which comprises a piezo damper formed by a pair of piezo elements for damping the elastic deformation of the function element;
Fig. 4a is a schematic illustrative view of the exemplary function elements comprising respective piezo dampers of Figs. 2 and 3 with associated electronic circuits connecting the piezo elements of the respective pair of piezo elements with each other;
Fig. 4b is a schematic illustrative view of exemplary electronic circuits connecting the piezo elements of the respective pair of piezo elements with each other;
**Fig. 5** is a schematic illustrative view of the exemplary deformations of Fig.1 with the provision of (a) a piezo damper formed by a pair of piezo elements and an associated electronic circuit and (b) three piezo dampers formed by a pair of piezo elements each and associated electronic circuits;
Fig. 6a is a schematic illustrative view of exemplary piezo dampers with respective electronic circuits being symmetrically provided at the function element in respect to two oscillation axes;
Fig. 6b is a schematic illustrative view of exemplary piezo dampers with respective electronic circuits being symmetrically provided at the function element in respect to two oscillation axes;
**Fig. 7** is a schematic flow chart exemplarily illustrating a method for manufacturing the MEMS device;
**Fig. 8a** is a schematic exemplary cross-section view of the MEMS device manufactured according to the exemplary method for manufacturing the MEMS device of **Fig. 7****;**
**Fig. 8b** is a schematic exemplary cross-section view of another MEMS device manufactured according to the exemplary method for manufacturing the MEMS device of **Fig. 7**;
**Fig.8c** is a schematic exemplary cross-section view of another MEMS device manufactured according to the exemplary method for manufacturing the MEMS device of **Fig. 7****.**

### Detailed Description of the Drawings and Exemplary Embodiments

In the following, preferred exemplary aspects and exemplary embodiments of the present disclosure will be described in more detail with reference to the accompanying figures. Same or similar features in different drawings and exemplary embodiments are referred to by similar reference numerals. It is to be understood that the detailed description below relating to various preferred exemplary aspects and preferred exemplary embodiments are not to be meant as limiting the scope of the present disclosure.

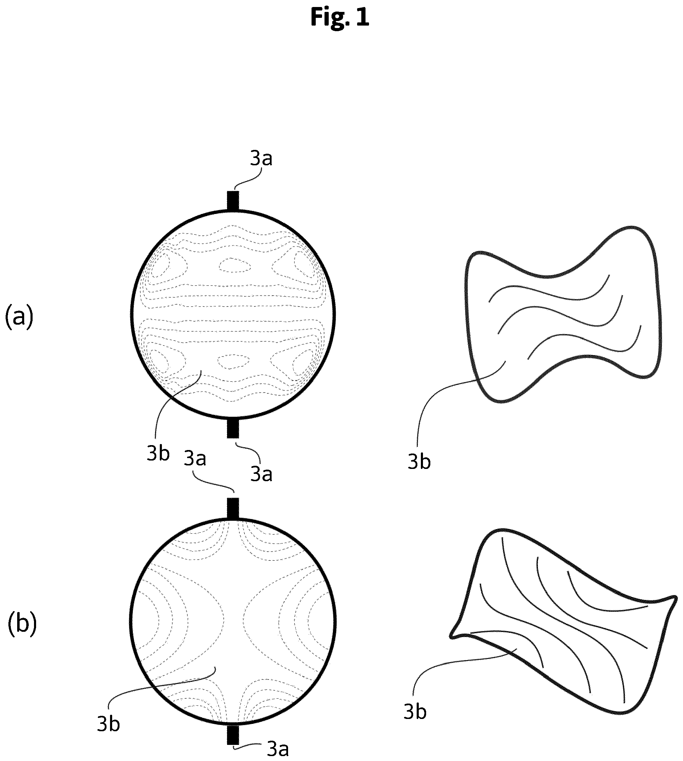

**Fig. 1** is a schematic illustrative view of exemplary elastic deformations of the function element 3b occurring during oscillation of the function element 3b.

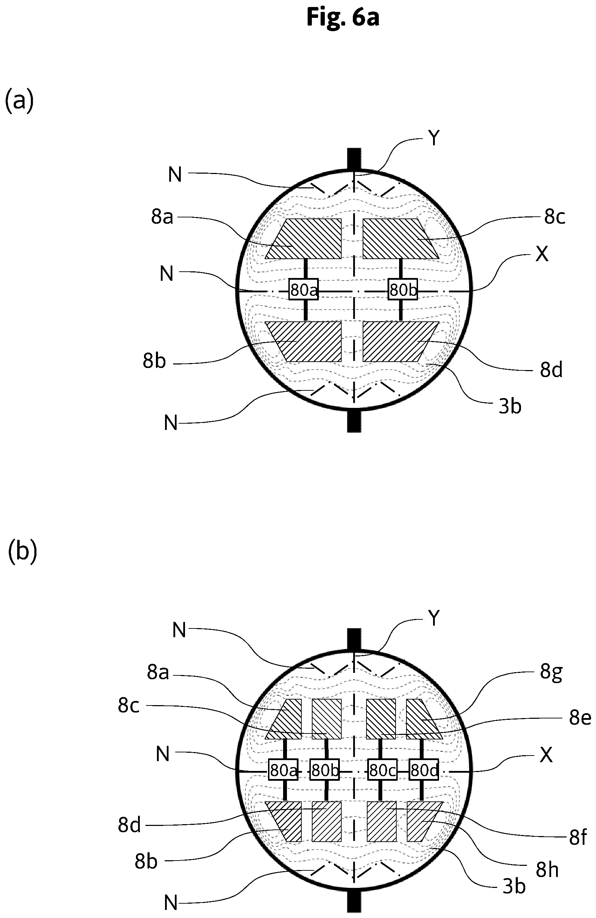

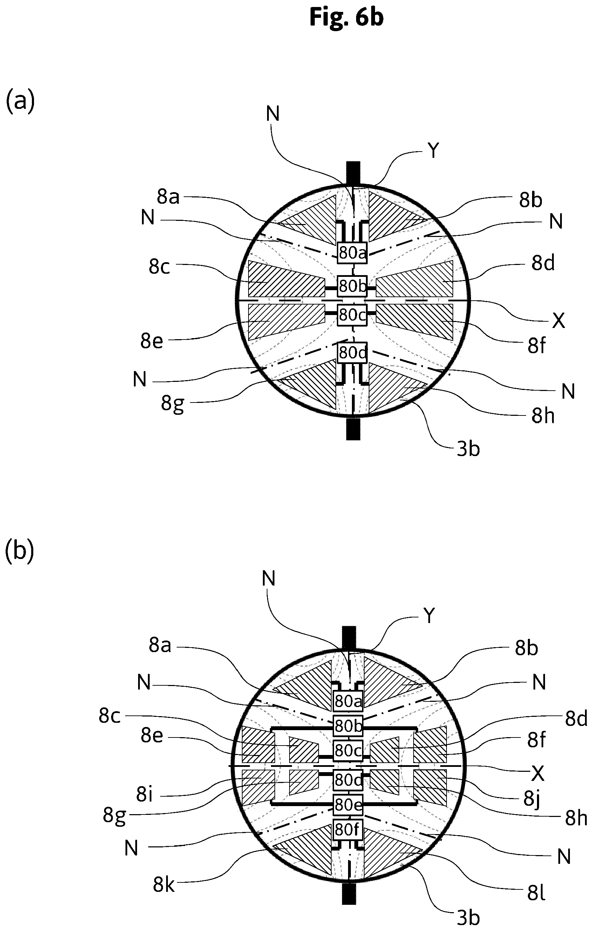

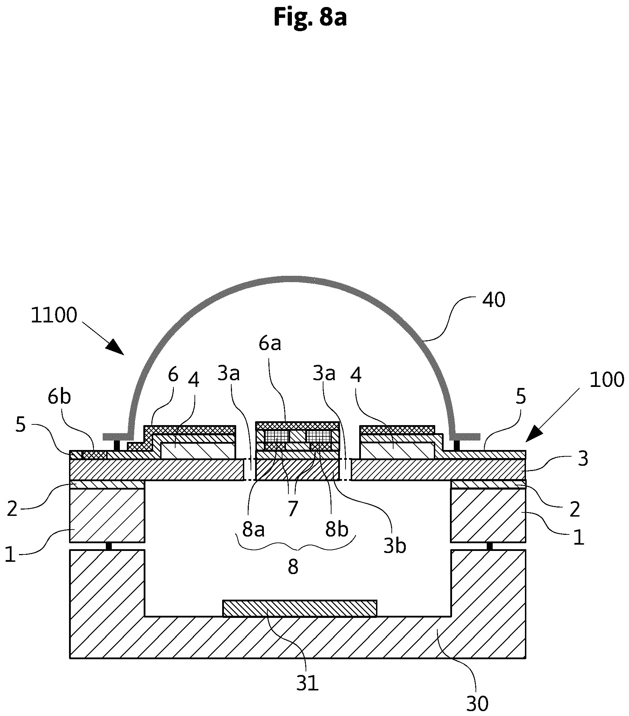

The MEMS device 1100 - 1300 as it is described in more details in **Figs. 8a** - **8c** can comprise, for example, a device layer 3 comprising spring sections 3a and a function element 3b being spring-mounted by the spring sections 3a (spring sections 3a and function element 3b build together an oscillating system), wherein the function element 3b is configured to be driven to oscillate along and/or about at least one oscillation axis X, Y (please refer for the oscillation axes X, Y to, for example, Figs. 6a and 6b), in particular to oscillate in at least one transverse normal mode of the oscillating system.

However, because of the inertia of the function element 3b and the associated resonant frequency of the oscillating system / oscillating parts of the device layer 3, alternating elastic deformations of the function element 3b can occur within the running / operation of the MEMS device 1100 - 1300 that can lead to a degradation in quality and reliability of the function of the MEMS device 1100 -1300, for example in case of an oscillation frequency of the function element 3b in a range of 1/10 of the first resonant frequency (first transverse normal mode) up to higher resonant frequencies (like 5^{th} or 6^{th} transverse normal mode).

For example, a MEMS device 1100 -1300 that is used for measurement tasks (as sensor) can measure accelerations or angular displacements with less accuracy because of elastic deformations of the function element 3b. Further, if the MEMS device 1100 - 1300 is used as micromirror with a reflecting surface at the function element 3b, which will be deformed (e.g. bend) by the deformations of the function element 3b too, cannot reflect the incident electromagnetic radiation (like a laser beam etc.) in the desired quality and precision.

**Fig. 1 (a)** shows an exemplary elastic deformation of the function element 3b being spring-mounted by two spring sections 3a which could result from an oscillation frequency of the function element 3b being the resonant frequency of the oscillating system, wherein the exemplary deformation of the function element 3b as shown in **Fig. 1 (a)** is not proportionally to the real amount of deformation.

**Fig. 1 (b)** shows another exemplary elastic deformation of the function element 3b being spring-mounted by the two spring sections 3a which could result from an oscillation frequency of the function element 3b being the resonant frequency of the oscillating system, wherein the exemplary deformation of the function element 3b as shown in **Fig. 1 (b)** is not proportionally to the real amount of deformation.

However, it is to be noticed that also other oscillation frequencies of the function element 3b than oscillation frequencies being the resonant frequency of the oscillating system or a combination of different oscillation frequencies (for example, as in case of a 2D oscillation application of the MEMS device 1100 - 1300 having two oscillation axes with different oscillation frequencies) can lead to comparable or other deformation shapes of the function element 3b that are focus of the following described solution for damping elastic deformations.

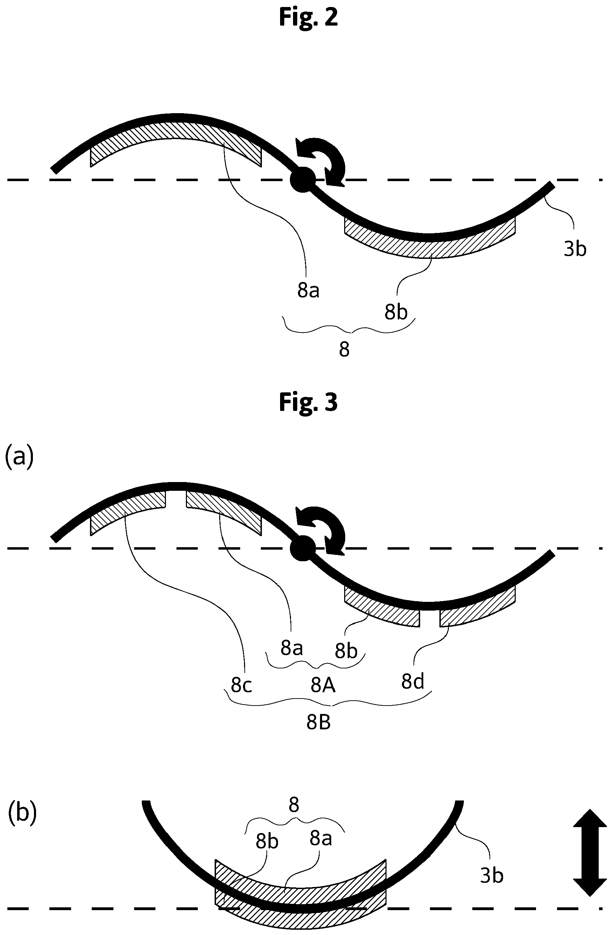

**Fig. 2** is a schematic illustrative view of an exemplary deformed function element 3b with a piezo damper 8 formed by a pair of piezo elements 8a, 8b for damping the elastic deformations of the function element 3b.

The above-described drawbacks of alternating elastic deformations of the function element 3b can be, for example, reduced or, in the best way, fully prevent by applying at least one piezo damper 8 at the function element 3b which is configured to damp said alternating elastic deformations of the function element 3b resulting from the oscillation, for example, by transforming the mechanical energy of the alternating elastic deformations to electrical energy or by generating mechanical force acting against the alternating elastic deformations based on provided electrical energy.

As described under **Fig. 1****,** shapes of said alternating elastic deformations of the function element 3b can differ in locations within the function element 3b, or in respect to amplitudes and magnitudes.

Therefore, it can be preferred to determine said locations of elastic deformations before applying the respective piezo damper 8 at the function element 3b and to provide the at least one piezo damper 8 at said predetermined locations of alternating elastic deformations of the function element 3b.

A determination of the elastic deformations of the function element 3b can be performed on the basis of an analysis of the function element 3b under the desired oscillation (for example, by computer-aided simulation of a respective model of the function element 3b, as it is shown in **Figs. 1 (a)** and **(b)**) or by testing the manufactured MEMS device 1100 - 1300 and measuring the respective deformations / deformation shapes of the function element 3b.

In case of the exemplary alternating elastic deformation of the function element 3b shown in **Fig. 2****,** which can occur for example because of a rotational oscillation of the function element 3b about an oscillation axis X, Y, the elastic deformation of the function element 3b in cross-sectional view can have a shape of a sine wave (in the respective moment that is shown in **Fig. 2**), for example with one valley and one peak (please see also **Fig. 1 (a)**) at the same time, wherein said peak and said valley can alternate in correspondence with the respective frequency of oscillation of the function element 3b.

To damp said elastic deformation most effectively, it can be preferably to provide the at least one piezo damper 8, which is in the present case a piezo damper 8 formed by a pair of (two) piezo elements 8a, 8b, at the respective locations of the alternating peak and valley of said sinusoidal deformation of the function element 3b, which means that one piezo element 8a of the at least one piezo damper 8 is provided at the peak of the sinusoidal deformation, while the other piezo element 8b of the at least one piezo damper 8 is provided at the valley of the sinusoidal deformation.

The used effect is that the deformation of the respective part of the function element 3b will result in a deformation and, thereby, in a mechanical stress of the respective piezo elements 8a, 8b. The mechanical stress of the piezo elements 8a, 8b result in a shifting of the center of the electric charge (a charge separation in the individual atoms of the material) that forms a dipole and, thereby, a voltage at the respective piezo elements 8a, 8b (direct piezoelectric effect).

This means, beside the fact that the piezo elements 8a, 8b being applied at the function element 3b damp the elastic deformation by the additionally applied piezo material (the function element 3b has a thicker layer thickness at these locations by the piezo elements 8a, 8b), the direct piezoelectric effect supports the damping of said deformations additionally by detracting the mechanical energy from the locations of deformation (e.g. bending of the function element 3b) and transforms it to electrical energy.

Further, in the present example, it is shown in **Fig. 2** that the piezo elements 8a, 8b forming the at least one piezo damper 8 are placed at a side / a surface of the function element 3b, wherein one piezo element 8a is provided at a concave shape of the surface of the function element 3b, while at the same time the other piezo element 8b is provided at a convex shape of the surface of the function element 3b, wherein the concave shape and the convex shape of the surface of the function element 3b occur at the same time.

This means, in the moment of deformation of the function element 3b as shown in **Fig. 2****,** the piezo element 8a receives a mechanical compression stress, while the other piezo element 8b of the piezo elements 8a, 8b receives a mechanical tension stress and both stresses lead to the above-described direct piezoelectric effect and the respective damping of the alternating elastic deformations of the function element 3b.

However, even if it is shown in **Fig. 2** that both piezo elements 8a, 8b are placed / provided at one surface of the function element 3b, it is also possible that the piezo elements 8a, 8b can be placed at different sides / surfaces of the function element 3b, so that, for example, both piezo elements 8a, 8b receive a mechanical tension stress or a mechanical compression stress at the same time. Further, both piezo elements 8a, 8b can be placed at the location of the peak or at the location of the valley of the elastic deformed function element 3b (for example, as it is shown in **Fig. 3 (b)**), wherein one of the piezo elements 8a, 8b will receive a mechanical compression stress (like piezo element 8a as shown in **Fig. 3 (b)**) and the other one of the piezo elements 8a, 8b will receive a mechanical tension stress (like piezo element 8b as shown in **Fig. 3 (b)**) at the same time.

**Fig. 3** is a schematic illustrative view of a function element 3b exemplarily deformed during rotational oscillation, which comprises two piezo dampers 8A, 8B formed by a pair of piezo elements 8a to 8d each for damping the alternating elastic deformations of the function element 3b (see **Fig. 3 (a)**), and a schematic illustrative view of a function element 3b exemplarily deformed during translatory oscillation, which comprises a piezo damper 8 formed by a pair of piezo elements 8a, 8b for damping the deformation of the function element 3b (see **Fig. 3 (b)**).

With respect to the deformed function element 3b and the provision of a piezo damper 8 formed by the pair of piezo elements 8a, 8b as shown in **Fig. 2****,** the same deformed function element 3b can be also provided with two piezo dampers 8A, 8B as shown in **Fig. 3 (a)****,** wherein each piezo damper 8A, 8B is formed by a pair of piezo elements 8a to 8d (piezo damper 8A formed by piezo elements 8a, 8b; piezo damper 8B formed by piezo elements 8c, 8d).

A higher number of piezo elements 8a to 8d can be preferable to address different locations of alternating elastic deformations, especially in case of changing oscillation frequencies that can lead to different deformation shapes of the function element 3b. Further, also a different oscillation excitation in case of, for example, two-dimensional (2D) rotational oscillation of the function element 3b with changing frequency ratios (for example ratios of oscillation frequency of axis X to oscillation frequency of axis Y, see for example Figs. 6a and 6b) can lead to different deformation shapes of the function element 3b.

In any way, all piezo elements 8a to 8d as shown in **Fig. 3 (a)** can damp the deformation of the function element 3b by its respective additional layer thickness and their direct piezoelectric effect.

Further, as described under **Fig. 2****,** it is also possible that elastic deformations of the function element 3b can occur during a translatory oscillation of the function element 3b as it is shown in **Fig. 3 (b)****.**

In this case, the piezo elements 8a, 8b forming the piezo damper 8 also can be preferably applied at opposite surfaces of the function element 3b to damp said deformations. In this moment as shown in **Fig. 3 (b)**, one piezo element 8a of the pair of piezo elements 8a, 8b receives a mechanical compression stress (because of being provided at the surface of the function element 3b which has a concave shape at this moment) and the other piezo element 8b of the pair of piezo elements 8a, 8b receives a mechanical tension stress (because of being provided at the surface of the function element 3b which has a convex shape at this moment).

However, both piezo elements 8a, 8b as shown in **Fig. 3 (b)** can damp the deformation of the function element 3b by its respective additional layer thickness and their direct piezoelectric effect.

It is to be noticed that the shown deformation shapes of the function element 3b of **Figs. 3 (a)** and **(b)** are only examples of deformations and are not limiting the deformation shapes occurring during the plurality of different excitation possibilities of oscillations of the function element 3b to them.

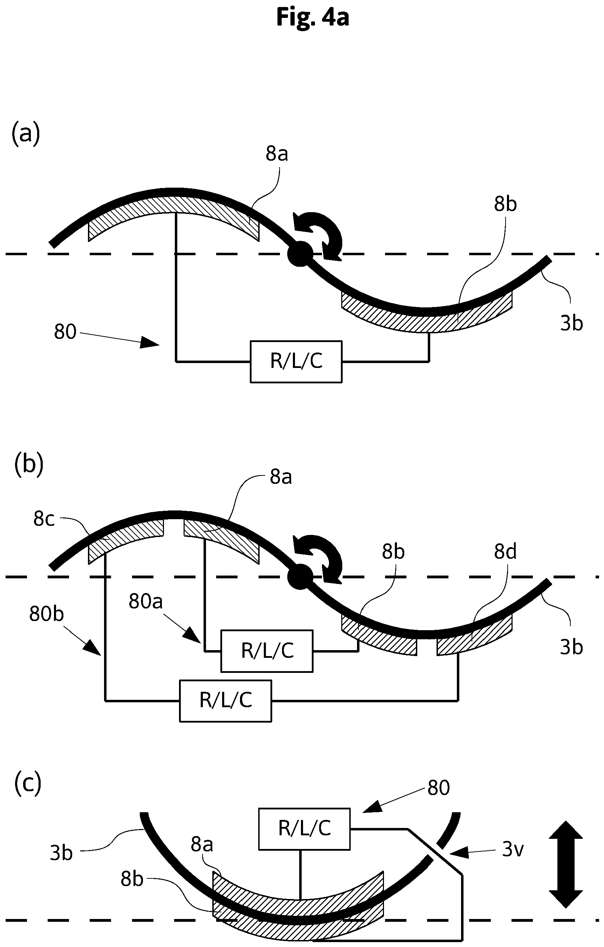

Fig. 4a is a schematic illustrative view of the exemplary function elements 3b comprising respective piezo dampers formed by piezo elements 8a, 8b, 8c, 8d of **Figs. 2** and **3** with associated electronic circuits 80, 80a, 80b connecting the piezo elements 8a to 8d of the respective pair of piezo elements 8a,8b and 8c,8d with each other.

It can be preferable to electrically connect the piezo elements 8a to 8d with each other by electronic circuits 80, 80a, 80b (also named as shunts), wherein said electronic circuits 80, 80a, 80b can comprise at least one of resistance R, capacitance C and/or inductance L and can be configured to transform the electrical energy generated by the pair of piezo elements 8a - 8d to another energy type or to provide electrical energy to each piezo element of the respective pair of piezo elements 8a - 8d for generating mechanical force acting against the alternating elastic deformations.

For example, a resistance R can take the electric energy generated by the piezo elements 8a to 8d and transform said electric energy to another energy type (for example, to heat energy). By doing so, the amount of energy deforming the function element 3b can be additionally reduced which lead to an increased damping effect of the alternating elastic deformations of the function element 3b.

Further, it can be preferable that the electric charges of the piezo elements 8a to 8d generated by the deformation of the respective piezo element 8a to 8d can be transferred through the electronic circuits 80, 80a, 80b (shunts) to the respectively other piezo element 8a to 8d being electrically connected with the electric charges generating piezo element 8a to 8d. These transmitted charges can potentially generate a response in the respective other piezo element 8a to 8d in terms of a counter-actuation (the respective other piezo element 8a to 8d works for a short moment as a piezo actuator triggered by the electric charge transmitted from the electric charges generating piezo element 8a to 8d), so that an increased damping behavior of the respective other piezo element 8a to 8d can be achieved.

However, said counter-acting response of the other piezo element 8a to 8d can be further optimized by the combination of a resistance R with one of capacitance C and inductance L to form the electronic circuit 80, 80a, 80b. These combinations of electronic elements can provide, for example, a desired impedance of said electronic circuit 80, 80a, 80b and, thereby, can improve the impedance of the all circuit (electronic circuit 80, 80a, 80b and piezo elements 8a to 8d) which can be specific for a respective application of the MEMS device 1100 -1300 (for example, as sensor or as micromirror etc.).

Another example can be the combination of at least a capacitance C and an inductance L to form a resonant circuit as electronic circuit 80, 80a, 80b. Said resonant circuit can have, for example, a circuit frequency that is aligned with the oscillation frequency of the function element 3b to improve the impedance of the electronic circuit 80, 80a, 80b in respect to the impedance of the piezo elements 8a to 8d and, thereby, to further optimize the damping effect of the applied piezo dampers 8 formed by the respective pairs of piezo elements 8a to 8d.

However, it is to be noticed that the resonant frequency of the resonant circuit is not necessarily in alignment with the oscillation frequency of the function element 3b. A deviation of the resonant frequency of the resonant circuit from the oscillation frequency of the function element 3b can also lead to a moderate tuning of the damping effect.

Fig. 4a (a) shows the deformed function element 3b with the piezo elements 8a, 8b as shown in **Fig. 2****,** but now the piezo elements 8a, 8b are electrically connected with each other by the electronic circuit 80. Further, Fig. 4a (b) shows the deformed function element 3b with the piezo elements 8a to 8d as shown in **Fig. 3 (a)****,** but now the piezo elements 8a to 8d are pair-wise electrically connected with each other by the electronic circuits 80a, 80b, wherein the piezo elements 8a, 8b are connected with each other via electronic circuit 80a, and piezo elements 8c, 8d are connected with each other via electronic circuit 80b.

Fig.4a (c) shows the deformed function element 3b with piezo elements 8a, 8b as shown in **Fig. 3 (b)****,** but now the piezo elements 8a, 8b are electrically connected with each other by the electronic circuit 80. Since the piezo elements 8a, 8b are provided at the function element 3b at opposite surfaces, it can be of advantage to provide a via 3v, which can be a hole that passes through the function element 3b and which is filled with conductive material to transmit electric charges of the one piezo element 8a provided at one surface of the function element 3b to the piezo element 8b provided at the opposite surface of the function element 3b, so that both piezo elements 8a, 8b can be electrically connected with each other.

However, it is to be noticed that vias can lead to strain concentration in the function element 3b which should be considered in the calculations of the design of the function element 3b to avoid failure.

Since the piezo elements 8a to 8d (and further ones) are provided at the function element 3b to damp the alternating elastic deformation, it can be preferable if the electronic circuit 80, 80a, 80b is also provided at the function element 3b. This can lead to a prevention of applying conductive material additionally at the spring sections 3a of the device layer 3 to connect the piezo elements 8a to 8d with an electronic circuit out of the oscillating parts (like function element 3b and spring sections 3a) of the device layer 3, which can lead to a better reliability of the oscillation behavior of the oscillating parts and to less failure possibilities.

For example, the electronic circuit 80, 80a, 80b can be provided at a side of the function element 3b at which the at least one piezo damper 8 (formed by the respective pair of piezo elements 8a, 8b and 8c, 8d) is provided.

As another example, it can be also possible to provide the electronic circuit 80, 80a, 80b at a side of the function element 3b that is opposite to a side of the function element 3b at which the at least one piezo damper 8 (formed by the respective pair of piezo elements 8a, 8b and 8c, 8d) is provided. In this case, it can be further advantageous if at least one via is provided in the function element 3b too.

Moreover, as another example, if more than one piezo damper 8 formed by the respective pair of piezo elements 8a, 8b is provided at the function element 3b, wherein the piezo dampers 8 are provided at opposite sides / surfaces of the function element 3b, it can be of advantage to provide the respective electronic circuit 80, 80a, 80b at the respective side / surface at which the respective piezo damper 8 is provided.

In a case where the piezo elements 8a, 8b forming the at least one piezo damper 8 are provided at opposite sides / surfaces of the function element 3b (as it is shown in Fig. 4a (c)), the surface / side for providing the electronic circuit 80 can be either the side of piezo element 8a, or the side of piezo element 8b. However, with respect to manufacturing steps, it can be preferred to form the electronic elements (like resistance R, capacitance C or inductance L) forming the electronic circuit 80 at one common side / surface of the function element 3b.

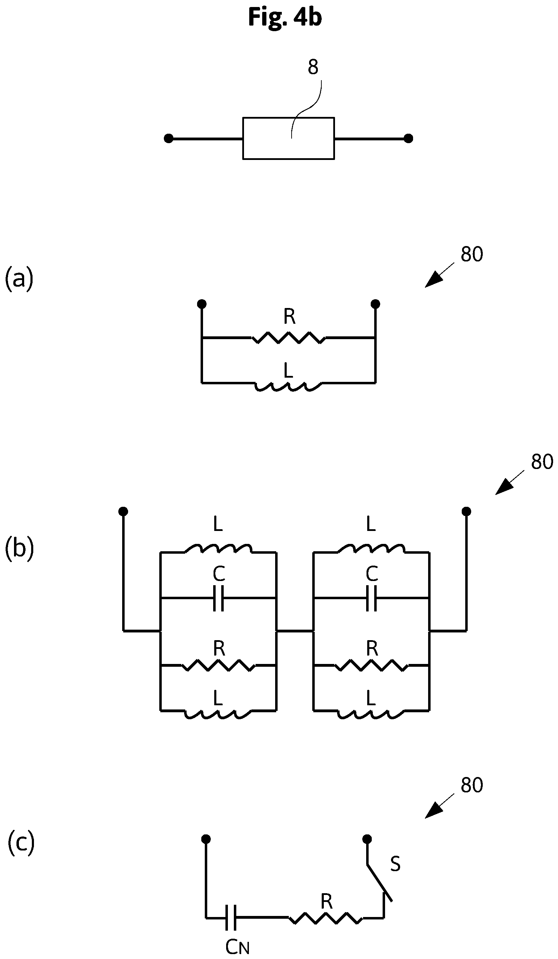

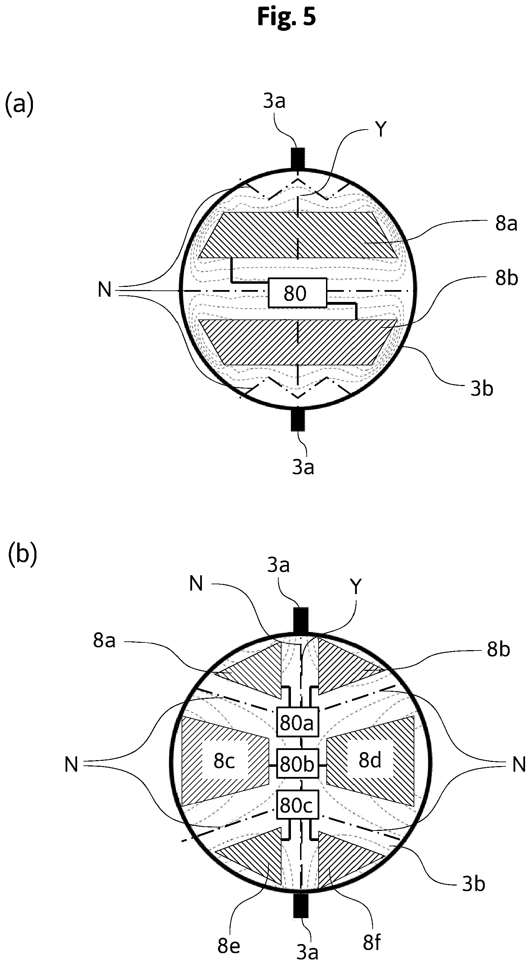

Fig. 4b is a schematic illustrative view of exemplary electronic circuits 80 (see for example Figs. 5 - 6b; also applicable for electronic circuits 80a - 80f) for connecting the piezo elements of the respective pair of piezo elements of the piezo damper 8 with each other.

For example, as shown in picture **a),** the exemplary electronic circuit 80 can comprise a resistance R and an inductance L being connected in parallel for providing a resonant circuit, which could be applied for connecting the respective piezo elements of the piezo damper 8 with each other to damp the alternating elastic deformations.

Further, as shown in picture **b),** the exemplary electronic circuit 80 can comprise, beside a resistance R and an inductance L as shown in picture **a),** another inductance L and a capacitance C, wherein all electronic components being connected in parallel. This combination of electronic components builds a more complex resonant circuit than the one shown in picture **a).**

However, for example, said more complex resonant circuit can be provided two times being connected in series to damp the alternating elastic deformations, wherein said complex structure can be advantageous for addressing more than one shape of elastic deformations of the function element 3b.

Another exemplary electronic circuit 80 is shown in picture **c)** which comprises a resistance R and a negative capacitance C_{N}, wherein said electronic circuit 80 is further switchable by a switch 5 (also named as synchronized switched damping SSD). This configuration of electronic circuit 80 can be advantageous to synchronize the voltage applied to the respective piezo element of the piezo damper 8 with the rate of elastic deformations occurring at the location of the respective piezo element.

However, it is to be noticed that the above-mentioned exemplary electronic circuits 80 are only examples and could be adapted in different ways.

**Fig. 5** is a schematic illustrative view of the exemplary deformations of **Fig. 1** with the provision of a piezo damper 8 formed by a pair of piezo elements 8a, 8b and an associated electronic circuit 80 (as it is shown in **Fig. 5 (a)**) and the provision of three piezo dampers 8 formed by a pair of piezo elements 8a, 8b and 8c, 8d and 8e, 8f each and associated electronic circuits 80a, 80b, 80c (as it is shown in **Fig. 5 (b)**).

As it is already described, the function element 3b of the MEMS device 1100 - 1300 can be exemplarily driven to oscillate with an oscillation frequency being the resonant frequency of the oscillating system, wherein the respective resonant frequency leads to respective deformation shapes (specific shape of alternating elastic deformations) of the function element 3b.

In the present case of **Fig. 5 (a)** showing exemplarily the function element 3b hold by two spring sections 3a, the determined elastic deformations can relate to the exemplary deformation shape of the function element 3b as shown in **Fig.1 (a)**.

Therefore, it can be preferred to provide the piezo elements 8a, 8b at locations of the function element 3b which are determined as receiving the most significant elastic deformations when oscillated with the respective oscillation frequency, which can be, in the shown case, the peak and the valley of the exemplary deformation shape of the function element 3b (in the moment of deformation as shown in **Fig. 5 (a)**).

In this respect, the piezo elements 8a, 8b forming the at least one piezo damper 8 can be provided at the predetermined locations of the function element 3b adjacent to at least one region N of non-deflection from the average plane of the function element 3b, which is shown in **Fig. 5 (a)** (and further figures) as chain dotted line N. The average plane of the function element 3b is in this context the plane the function element 3b would have / would build if the function element 3b would have an infinite stiffness and, therefore, no deformation because of inertial forces or the like.

In another example, one piezo element 8a of the pair of piezo elements 8a, 8b can be provided at the function element 3b at a side of the at least one region N of non-deflection from the average plane of the function element 3b and the other one piezo element 8b of the pair of piezo elements 8a, 8b can be provided at the function element 3b at the other side of the at least one region N of non-deflection from the average plane of the function element 3b, wherein one pair of piezo elements 8a, 8b corresponds to one region N of non-deflection from the average plane of the function element 3b.

In another example, the piezo elements 8a, 8b of the pair of piezo elements 8a, 8b of the at least one piezo damper 8 are provided at the function element 3b symmetrically to the at least one region N of non-deflection from the average plane of the function element 3b (here, the region N being located horizontally and being substantially in the middle of the deformed function element 3b).

Further, it is to be noticed that the piezo elements 8a, 8b in **Fig. 5 (a)** can be exemplarily provided at a common side of the function element 3b together with its respective electronic circuit 80. Said electronic circuit 80 can be, for example, provided at the at least one region N of non-deflection from the average plane of the function element 3b (here, the region N substantially in the middle of the function element 3b) to receive elastic deformations as low as possible. However, any other location for providing the electronic circuit 80 at the function element 3b can be adequate too.

In the present case of **Fig. 5 (b)** showing exemplarily the function element 3b hold by two spring sections 3a, the determined elastic deformations can relate to the exemplary deformation shape of the function element 3b as shown in **Fig. 1 (b)****.**

Therefore, it can be, also in the case as shown in **Fig. 5 (b)****,** preferred to provide the piezo elements 8a to 8f at locations of the function element 3b which are determined as receiving the most significant elastic deformations when oscillated with the respective oscillation frequency, which can be, in the shown case, the peaks and the valleys of the exemplary deformation shape of the function element 3b (in the moment of deformation as shown in **Fig. 5 (b)**).

Also, these piezo elements 8a to 8f can form pair-wise the respective piezo dampers 8, wherein piezo elements 8a, 8b are paired, the piezo elements 8c, 8d are paired, and the piezo elements 8e, 8f are paired. Said piezo elements 8a to 8f are provided at the function element 3b symmetrically to the at least one region N of non-deflection from the average plane of the function element 3b (here, the region N being located vertically and being substantially in the middle of the deformed function element 3b).

Moreover, the function element 3b can comprise at least one pair of mounting points of the spring sections 3a being mounted with the function element 3b, wherein the piezo elements 8a to 8f forming the respective piezo dampers 8 are provided adjacent to an imaginary straight line between the mounting points of the at least one pair of mounting points (here it is the line that corresponds to the oscillation axis Y).

Further to this, one piezo element 8a, 8c, 8e of the respective pair of piezo elements 8a to 8f is provided at the function element 3b at a side of the imaginary straight line (line corresponding to oscillation axis Y) and the other one piezo element 8b, 8d, 8f of the respective pair of piezo elements 8a to 8f is provided at the function element 3b at the other side of the imaginary straight line (line corresponding to oscillation axis Y), wherein one pair of piezo elements 8a to 8f can correspond to a single imaginary straight line.

In a further example, the piezo elements 8a to 8f of the pair of piezo elements 8a to 8f of the at least one piezo damper 8 (here, three pairs of piezo elements 8a, 8b and 8c, 8d and 8e, 8f forming respectively three piezo dampers 8) are provided at the function element 3b symmetrically to the imaginary straight line (line corresponding to oscillation axis Y) of the at least one pair of mounting points.

In another example, the piezo elements 8a to 8f of the pair of piezo elements of the at least one piezo damper 8 are provided at the function element 3b symmetrically to the at least one region N of non-deflection from the average plane of the function element 3b (vertical region N) and to the imaginary straight line (line corresponding to oscillation axis Y) of the at least one pair of mounting points.

It is, again, to be noticed that the piezo elements 8a to 8f in **Fig. 5 (b)** can be exemplarily provided at a common side of the function element 3b together with its respective electronic circuits 80a, 80b, 80c. Said electronic circuits 80a, 80b, 80c can be, for example, provided at the at least one region N of non-deflection from the average plane of the function element 3b (here, the vertical region N substantially in the middle of the function element 3b) to receive elastic deformations as low as possible. However, any other locations for providing the electronic circuits 80a, 80b, 80c at the function element 3b can be adequate too.

However, as another example, the piezo elements 8a to 8f (or only a part of them) can be provided at a side of the function element 3b at which the function surface 6a is provided. In particular, the piezo elements 8a to 8f of the respective piezo dampers 8 can be provided at the side of the function element 3b aside the function surface 6a and, thereby, supporting the bending compensation of the function surface 6a.

Fig. 6a is a schematic illustrative view of exemplary piezo dampers formed pair-wise by piezo elements 8a to 8d (piezo elements 8a, 8b are paired and piezo elements 8c, 8d are paired) with respective electronic circuits 80a, 80b being symmetrically provided at the function element 3b of **Fig. 5 (a)** in respect to two oscillation axes X, Y.

In case of 2D oscillation applications of the MEMS device 1100 - 1300 it could be preferred to provide the respective piezo elements 8a to 8d symmetrically not only to the at least one region N of non-deflection from the average plane of the function element 3b and the imaginary straight line (line corresponding to oscillation axis Y) of the at least one pair of mounting points, but also to the second oscillation axis X.

By this exemplary configuration of providing the piezo elements 8a to 8d at the function element 3b as shown in Fig. 6a (a), potential other shapes of elastic deformations resulting from the interference of two (mainly different) oscillation frequencies of said two oscillation axes X, Y can be addressed.

In another example, as shown in Fig. 6a (b), the number of pairs of piezo elements 8a to 8h can be further risen, for example, to four pairs of piezo elements (piezo elements 8a, 8b are paired, piezo elements 8c, 8d are paired, piezo elements 8e, 8f are paired, and piezo elements 8g, 8h are paired) with respective electronic circuits 80a, 80b, 80c, 80d, to potentially address further shapes of deformation of the function element 3b.

Especially in case of the occurrence of different shapes of deformation, for example, in case of an oscillation of the function element 3b along and/or about two oscillation axes X,Y with different oscillation frequencies, so that the function element 3b is deformed according to different shapes of deformation with respectively different locations of elastic deformations, the provision of smaller, but more piezo elements 8a - 8h being electrically connected pair-wise by a respective electronic circuit 80a - 80d can advantageously address these different shapes of deformation with one configuration of applied piezo elements 8a - 8h.

Fig. 6b is a schematic illustrative view of exemplary piezo dampers formed pair-wise by piezo elements 8a to 8h (piezo elements 8a, 8b are paired, piezo elements 8c, 8d are paired, piezo elements 8e, 8f are paired, and piezo elements 8g, 8h are paired) with respective electronic circuits 80a to 80d being symmetrically provided at the function element 3b of **Fig. 5 (b)** in respect to two oscillation axes X, Y.

Also in this exemplary case, it can be preferred to provide the respective piezo elements 8a to 8h symmetrically not only to the at least one region N of non-deflection from the average plane of the function element 3b and the imaginary straight line (line corresponding to oscillation axis Y) of the at least one pair of mounting points, but also to the second oscillation axis X.

In another example, as shown in Fig. 6b (b), the number of pairs of piezo elements 8a to 8l can be further risen, for example, to six pairs of piezo elements (piezo elements 8a, 8b are paired, piezo elements 8c, 8d are paired, piezo elements 8e, 8f are paired, piezo elements 8g, 8h are paired, piezo elements 8i, 8j are paired, and piezo elements 8k, 8l are paired) with respective electronic circuits 80a to 80f, to potentially address further shapes of deformation of the function element 3b.

The same applies in this case that the occurrence of different shapes of deformation can be advantageously addressed by the provision of smaller, but more piezo elements 8a - 8l being electrically connected pair-wise by a respective electronic circuit 80a - 80f, so that only one configuration of applied piezo elements 8a - 8l is necessary.

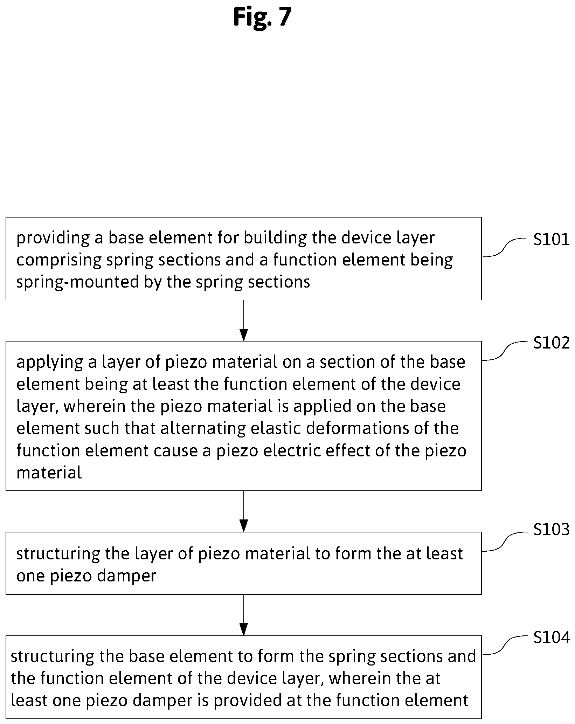

**Fig. 7** is a schematic flow chart exemplarily illustrating a method for manufacturing the MEMS device 1100 - 1300 as described in more details in **Figs. 8a** - **8c****.**

It is to be noticed that the process for manufacturing the piezo elements 8a to 8l forming the respective piezo dampers 8 and the respective electronic circuits 80a to 80f (shunts) can preferably relate to small-sized depositions and patterning of layers of different materials (like piezoelectric, conductive, dielectric materials) to realize said specific application of deformation damping elements.

In an exemplary step S101 of the method for manufacturing the MEMS device 1100 - 1300, a base element for building the device layer 3 comprising spring sections 3a and a function element 3b being spring-mounted by the spring sections 3a is provided.

Said base element can be, for example, an SOI wafer (silicon-on-insulate wafer) or a single layer wafer or a wafer with different material or material combinations.

In an exemplary further step S102 of the method for manufacturing the MEMS device 1100 - 1300, a layer of piezo material is applied at least on a section of the base element which will be the function element 3b of the device layer 3, wherein the piezo material is applied on the base element such that alternating elastic deformations of the function element 3b cause a piezo electric effect of the applied piezo material.

In an exemplary further step S103, the applied layer of piezo material is structured to form the at least one piezo damper 8, wherein, for example, wet-chemical or dry-chemical processes for structuring the piezo material can be used.

Further, the structuring of the layer of piezo material can comprise the forming of the at least one piezo damper 8 and the at least one actuator 4 (here as piezo actuator 4) configured to drive the function element 3b to oscillate along and/or about the at least one oscillation axis X, Y, in particular to drive the function element 3b to oscillate in at least one transverse normal mode.

It can be preferred that both the at least one piezo damper 8 as well as the at least one piezo actuator 4 can be formed in one step of structuring the applied piezo material layer, so that manufacturing time, energy and, thereby, manufacturing costs can be reduced.

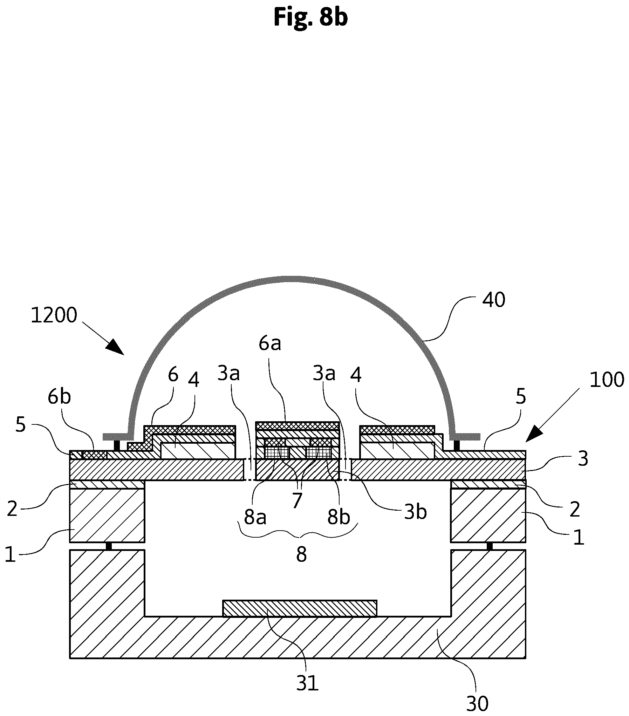

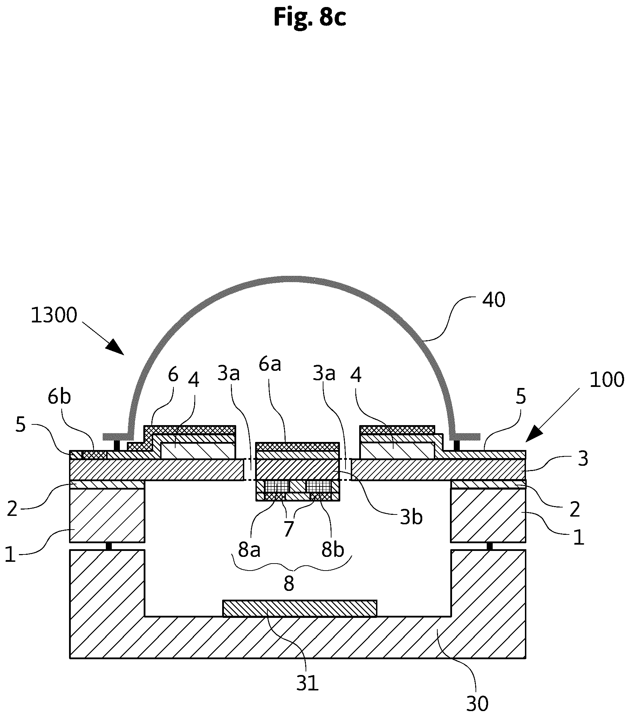

Further, the at least one piezo damper 8 and the at least one piezo actuator 4 can use the device layer 3 as a common ground electrode for their respective tasks as it is shown for the MEMS device 1200, 1300 in **Figs. 8b****,** **8c** (the at least one piezo damper 8 for damping alternating elastic deformations of the function element 3b; the at least one piezo actuator 4 for driving the function element 3b to oscillate).

In an exemplary further step S104, the base element is structured to form the spring sections 3a and the function element 3b of the device layer 3, wherein the at least one piezo damper 8 is provided at the function element 3b.

For example, when structuring the base element in step S104, high-frequency etching or deep reactive ion etching (DRIE) can be used to etch deep trenches in the base element for forming the respective spring sections 3a and the function element 3b of the device layer 3.

As another exemplary step S105, locations of alternating elastic deformations of the function element 3b resulting from an oscillation of the function element 3b along and/or about at least one oscillation axis X, Y of the MEMS device 1100 - 1300 are determined, wherein the piezo material is structured to form the at least one piezo damper 8 at the function element 3b at the respective determined locations of alternating elastic deformations of the function element 3b.

It can be of advantage if specific regions of elastic deformations of the function element 3b are determined to apply the at least one piezo damper 8 (or more than one piezo damper 8) at the respective predetermined locations to effectively damp the occurring deformations (either by transforming the electrical energy generated by the pair of piezo elements to another energy type or to provide electrical energy to each piezo element of the respective piezo damper 8 for generating mechanical force acting against the alternating elastic deformations).

As another exemplary step S106, a conductive layer is applied for building the electronic circuit 80, 80a, 80b (shown in **Figs. 8a** - **8c** as electrodes 7 for electrically contacting the respective piezo elements 8a, 8b), wherein said conductive layer can be applied either before applying the piezo material layer for forming the at least one piezo damper 8, or after it. It can depend, for example, on whether the device layer 3 is doped (and, thereby, conductive) or not.

It is to be noticed that the electronic circuits 80 to 80f defining the specific impedance can be, for example, fabricated in plane using deposition of layers of metal and dielectric as it is used typically in microsystem processes.

As another exemplary step S107, the applied conductive layer is structured to form the electronic circuit 80 electrically connected with the at least one piezo damper 8, wherein structuring the applied conductive layer comprises forming of at least one of resistance R, capacitance C and/or inductance L.

Further, the electronic circuits 80 (symbolized by the electrodes 7 in **Figs. 8a** - **8c**) can be formed as a resonant circuit 80. Moreover, the circuit frequency of said resonant circuit 80 can be, for example, aligned with the oscillation frequency of the function element 3b.

As another exemplary step S108, a function surface 6a is formed on the function element 3b, wherein the at least one piezo damper 8 is provided between the function surface 6a and the function element 3b.

Further, said function surface 6a can be a mirror 6a / mirror element 6a that is configured to reflect incident electromagnetic radiation. In this respect, it can be preferred to use chemical mechanical polishing (CMP) to improve the planarity of the surface below the function surface 6a being a mirror 6a to fulfill the mirror functionality.

However, it is to be noticed that processes which are associated with building the stack of different layers (like the function element 3b with the piezo damper 8, the electronic circuit 80 and the function surface 6b) can be advantageously applied in a respective order and/or with further intermediate processes to reach a flat surface of the function surface 6b, so that, beside a correct "structuration" of each layer in respect to the functionalization, a correct planarity is achieved to allow valid reflective capabilities.

In an example, the layer that forms the function surface 6a can comprise metal, in particular aluminum, so that the surface of the layer forming said function surface 6a already has a reflective surface and is suitable for forming the mirror 6a.

In this exemplary case, it can be preferred that the function surface 6a comprising conductive material (like aluminum) can be used as a second electrode for electrically contacting the applied piezo elements 8a, 8b so that an application of another conductive layer is not necessary and can reduce the manufacturing time and costs.

In further examples, it is possible to provide a non-reflective or non-metallic layer (e.g. doped polycrystalline silicon), in which case a further, e.g. metallic, mirror layer (e.g. as a thin-layer metal film) can be applied in the region of the layer of the function surface 6a.

However, it should be noticed that the herein given numbering of the method steps is not relating to a sequence of said method steps. For example, the step S105 of determining locations of elastic deformations of the function element 3b can be, for example, performed before step S103 of structuring the piezo layer to form the at least one piezo damper 8.

Further to this, the respective sequence of the method steps can be different in respect to the application of the piezo elements 8a to 8f at the base element and can be dependent on a conductive layer that potentially must be applied (like it is shown in **Fig. 8a**) before the application of the piezo material layer for forming the piezo elements 8a to 8f.

Moreover, additional steps for manufacturing said MEMS device 1100 - 1300 can be applied. For example, additional steps can be necessarily or advantageously performed to apply the piezo metal layer for forming the at least one piezo damper 8 at a side of the function element 3b which is opposite to a side of the function element 3b at which the function surface 6a is provided (as it is shown for MEMS device 1300 in **Fig. 8c**)**.**

**Fig. 8a** is a schematic exemplary cross-section view of the MEMS device 1100 manufactured according to the exemplary method for manufacturing the MEMS device 1100 of **Fig. 7****.**

In **Fig.8a****,** an exemplary MEMS device 1100 is shown that can have a layer structure 100 that can be, for example, vacuum-sealed by a bottom wafer 30 and a transparent dome 40 (for example, a glass dome).

The layer structure 100 comprises the device layer 3 having the function element 3b and the spring sections 3a (in **Fig. 8a** indicated by dotted lines), wherein the function element 3b is spring-mounted by the spring sections 3a. In the present example of MEMS device 1100, the function element 3b can be configured to oscillate along and/or about at least one oscillation axis X, Y (or about both oscillation axes X and Y), in particular to oscillate in at least one transverse normal mode.

The layer structure 100 can further comprise an intermediate layer 2 (e.g. an insulating passivation layer, for example made of silicon dioxide) and a base layer 1, wherein the intermediate layer 2 is exemplarily arranged between the base layer 1 and the device layer 3 of the layer structure 100. For example, an SOI wafer (silicon-on-insulator wafer) can be used for manufacturing said layer structure 100, wherein the base layer 1 is primary used as carrier wafer for carrying the typically thinner layers of intermediate layer 2 and device layer 3.

However, it is also possible that, instead of an SOI wafer, a one-layer wafer can be used as a basis for manufacturing the layer structure 100.

Further, the layer structure 100 exemplarily comprises at least one actuator 4 that drives the function element 3b to oscillate along and/or about the at least one oscillation axis X, Y, wherein said at least one actuator 4 can be formed as at least one piezo actuator 4 that operates by electric signals transmitted via electrodes 6 (formed by a layer of respective conductive material) and a ground electrode that can be, exemplarily, in the present case the device layer 3, if it is designed as conductive layer (for example, by appropriate doping).

Moreover, at the function element 3b, at least one piezo damper 8 formed by a pair of piezo elements 8a, 8b (or any other combinations of piezo elements 8a to 8f, for example, as shown in Figs. 2 to 6b) is exemplarily provided to damp alternating elastic deformations (for example, as shown in **Figs. 1 to 3**) of the function element 3b and its respective layers applied thereto.

The at least one piezo damper 8 can be configured to damp the elastic deformations of the function element 3b and of the function surface 6a by transforming the mechanical energy of the alternating elastic deformations to electrical energy or by generating mechanical force acting against the alternating elastic deformations based on provided electrical energy (for example, provided by the respective electronic circuit 80).

However, the damping of elastic deformations of the function element 3b by applying piezo elements 8a - 8f / piezo dampers 8 can lead to a further reduction of layer thickness of the function element 3b and/or of the device layer 3, respectively, since the stiffness of the function element 3b /device layer 3 does not need to be that high any more.

Further, an electronic circuit 80 (shown as electrode 7) being electrically connected with the at least one piezo damper 8 can be exemplarily provided; in the present case between a dielectric layer 5 applied at the function element 3b and the at least one piezo damper 8. Said electronic circuit 80 can comprise, for example, at least one of a resistance R, a capacitance C and/or an inductance L (for example, see Figs. 4a and 4b)**.**

Moreover, the layer structure 100 is mechanically connected with the bottom wafer 30 and the transparent dome 40 by exemplary glass frits (shown in **Fig. 8a** as small thick black lines) to isolate the inner area of the layer structure 100, where the function element 3b will oscillate, from environmental influences like air streaming, dust etc. and to achieve potentially a vacuum condition inside the MEMS device 1100.

Additionally, the bottom wafer 30 can comprise a getter 31 that can be used to maintain and control said vacuum inside the MEMS device 1100.

The layer structure 100 can further comprise a bond pad 6b to electrically connect the actuators 4 (here piezo actuators 4) with an outer periphery for controlling the drive of the oscillation of the function element 3b along and/or about at least one oscillation axis X, Y, in particular for controlling the drive of the oscillation of the function element 3b in at least one transverse normal mode.

**Fig. 8b** is a schematic exemplary cross-section view of the MEMS device 1200 manufactured according to the exemplary method for manufacturing the MEMS device 1100 - 1300 of **Fig. 7****.**

The MEMS device 1200 has substantially the same structure as the MEMS device 1100 as shown in **Fig. 8a****.** However, in contrast to MEMS device 1100 of **Fig. 8a****,** MEMS device 1200 comprises a device layer 3 at which the piezo elements 8a, 8b are formed directly, so that the device layer 3 can form a common ground electrode with the piezo actuators 4 of the MEMS 1200.

This can be preferred in respect to manufacturing steps, especially in structuring an applied piezo material layer to form piezo actuators 4 as well as the piezo elements 8a, 8b forming the at least one piezo damper 8.

**Fig. 8c** is a schematic exemplary cross-section view of the MEMS device 1300 manufactured according to the exemplary method for manufacturing the MEMS device 1100 - 1300 of **Fig. 7****.**

The MEMS device 1300 has substantially the same structure as the MEMS device 1100 as shown in **Fig. 8a****.** However, in contrast to MEMS device 1100 of **Fig. 8a****,** MEMS device 1300 comprises a device layer 3 at which the piezo elements 8a, 8b are formed directly and at the opposite side of the function element 3b in respect to the function surface 6a of the MEMS device 1300.

Beside the preferable aspect of a common ground electrode for the piezo actuators 4 and the piezo elements 8a, 8b, said MEMS structure can be further preferable in respect to planarity of the function surface 6a if used as mirror 6a, since no small sections of different material (like piezo material, conductive material and/or dielectric material) are applied between function surface 6a and function element 3b. This can improve the surface quality of the mirror 6a and, thereby, the quality and precision of reflecting, for example, an incident laser beam (or any other electromagnetic radiation)

Further, the structuring of the MEMS device 1300 can be also preferred in respect to manufacturing steps, even if the application of the material layers for forming the at least one piezo damper 8 (piezo elements 8a, 8b) and its respective electronic circuit 80 (here as shown as electrodes 7) is performed at the opposite side of the function surface 6a, which would require a turn-around of the layer structure 100.

If the planarity of the function surface 6a / mirror 6a is kept in high quality, further processing steps like chemical mechanical polishing (CMP) of the function surface 6a / mirror 6a can be potentially not necessary.

In the above, exemplary embodiments have been described, which advantageously allowing the integration of a piezo damper 8 at locations of the function element 3b (for example, having a function surface 6a that can be a micro-mirror) to compensate in real time the energy elastically deforming the function element 3b injected at each oscillation in the function element 3b. By doing so, the quantity of mechanical energy flowing at each half oscillation from one side to the other side of the function element 3b will be kept low and the bending / deforming of the function element 3b will reduce drastically.

Further, the described embodiments do not require extra wiring and energy consumption. Piezo elements 8a - 8f are locally applied and can be controlled by an electronic circuit 80 - 80f being applied at the function element 3b too. Moreover, the energy generated by each piezo element of the paired piezo elements can act to compensate the elastic deformation of the other piezo element and vice versa.

While certain exemplary embodiments have been described above and shown in the accompanying drawings, it is to be understood that such embodiments are merely illustrative of and are not restrictive on the broad disclosure, and that the exemplary embodiments of disclosure are not limited to the specific constructions and arrangements shown and described, since various other changes, combinations, omissions, modifications and substitutions, in addition to those set forth in the above paragraphs, are possible. Those skilled in the art will appreciate that various adaptations, modifications, and/or combination of the just described embodiments can be configured without departing from the scope of the disclosure. Therefore, it is to be understood that, within the scope of the appended claims, the disclosure may be practiced other than as specifically described herein. For example, unless expressly stated otherwise, the steps of processes described herein may be performed in orders different from those described herein and one or more steps may be combined, split, or performed simultaneously. Those skilled in the art will also appreciate, in view of this disclosure, that different embodiments of the disclosure described herein may be combined to form other embodiments of the disclosure.

### REFERENCE SIGNS LIST

- **1**: base layer
- **2**: intermediate layer
- **3**: device layer
- **3a**: spring sections
- **3b**: function element
- **3v**: via
- **4**: actuator; piezo actuator
- **5**: dielectric layer
- **6**: electrodes; conductive layer
- **6a**: function surface; mirror; mirror element
- **6b**: bond pad
- **7**: electrode
- **8**: piezo damper
- **8a** - **8l**: piezo elements forming the piezo damper
- **30**: bottom wafer
- **31**: getter
- **40**: transparent dome; glass dome
- **80,80a** - **80f**: electronic circuits
- **100**: layer structure
- **1100-1300**: MEMS device

## Claims

1. MEMS device (1100 -1300) comprising:
a device layer (3) comprising spring sections (3a) and a function element (3b) being spring-mounted by the spring sections (3a), wherein the function element (3b) is configured to be driven to oscillate along and/or about at least one oscillation axis (X, Y), and
at least one piezo damper (8) provided at the function element (3b) and configured to damp alternating elastic deformations of the function element (3b) resulting from the oscillation.

2. MEMS device (1100 -1300) according to claim 1, wherein
the at least one piezo damper (8) is provided at predetermined locations of alternating elastic deformations of the function element (3b), and
the at least one piezo damper (8) is configured to damp the alternating elastic deformations of the function element (3b) by transforming the mechanical energy of the alternating elastic deformations to electrical energy or by generating mechanical force acting against the alternating elastic deformations based on provided electrical energy.

3. MEMS device (1100 -1300) according to claim 1 or 2, wherein
the at least one piezo damper (8) is electrically connected with an electronic circuit (80, 80a - 80f) configured to transform the electrical energy generated by the at least one piezo damper (8) to another energy type or to provide electrical energy to the at least one piezo damper (8) for generating mechanical force acting against the alternating elastic deformations.

4. MEMS device (1100 -1300) according to claim 2, wherein
the at least one piezo damper (8) is formed by a pair of piezo elements (8a - 8l) being electrically connected with each other via an electronic circuit (80, 80a - 80f) configured to transform the electrical energy generated by the pair of piezo elements (8a - 8l) to another energy type or to provide electrical energy to each piezo element of the respective pair of piezo elements (8a - 8l) for generating mechanical force acting against the alternating elastic deformations.

5. MEMS device (1100 -1300) according to any one of the preceding claims, wherein
the at least one piezo damper (8) is provided at predetermined locations of the function element (3b) adjacent to at least one region (N) of non-deflection from an average plane of the function element (3b).

6. MEMS device (1100 - 1300) according to claim 5, wherein
one piezo element (8a) of a pair of piezo elements (8a, 8b) building the at least one piezo damper (8) is provided at the function element (3b) at a side of the at least one region (N) of non-deflection from the average plane of the function element (3b) and another one piezo element (8b) of the pair of piezo elements (8a, 8b) is provided at the function element (3b) at the other side of the at least one region (N) of non-deflection from the average plane of the function element (3b), wherein one pair of piezo elements (8a, 8b) corresponds to one region (N) of non-deflection from the average plane of the function element (3b).

7. MEMS device (1100 -1300) according to claim 4, wherein
one piezo element (8a - 8k) of the pair of piezo elements (8a - 8l) is provided at the function element (3b) at a predetermined location of convex shape or concave shape of a surface of the function element (3b) corresponding to the alternating elastic deformations and the other one piezo element (8b - 8l) of the pair of piezo elements (8a - 8l) is provided at the function element (3b) at a predetermined location of the respective other shape of a surface of the function element (3b), wherein the convex shape and the concave shape occur at the same time.

8. MEMS device (1100 -1300) according to any one of the preceding claims, further comprising:
at least two piezo dampers (8) formed by a pair of piezo elements (8a - 8l) each, wherein the piezo elements (8a - 8l) of the respective pair of piezo elements (8a - 8l) are electrically connected with each other via an electronic circuit (80, 80a - 80f) configured to transform the electrical energy generated by the respective pair of piezo elements (8a - 8l) to another energy type or to provide electrical energy to each piezo element of the respective pair of piezo elements (8a - 8l) for generating mechanical force acting against the alternating elastic deformations,
wherein the function element (3b) is configured to oscillate about two oscillation axes (X, Y), in particular to oscillate in two or more transverse normal modes, and
wherein the piezo elements (8a - 8l) of the at least two pairs of piezo elements (8a - 8l) are provided at the function element (3b) symmetrically to the two oscillation axes (X, Y).

9. MEMS device (1100 -1200; 1300) according to any of the preceding claims, further comprising:
a function surface (6a) that is provided at the function element (3b), wherein
the at least one piezo damper (8) is provided between the function surface (6a) and the function element (3b), or
the at least one piezo damper (8) is provided at a side of the function element (3b) that is opposite to a side of the function element (3b) at which the function surface (6a) is provided.

10. MEMS device (1100 -1200) according to any of claims 1 to 8, further comprising:
a function surface (6a) provided at the function element (3b), wherein
the at least one piezo damper (8) is provided at a side of the function element (3b) at which the function surface (6a) is provided.

11. MEMS device (1100 -1300) according to claim 9 or 10, wherein
the function surface (6a) comprises a mirror (6a) configured to reflect incident electromagnetic radiation, in particular an incident laser beam.

12. MEMS device (1100 -1300) according to claim 3 or 4, wherein
the electronic circuit (80, 80a - 80f) is a resonant circuit,
wherein the resonant circuit has a circuit frequency that is aligned with the oscillation frequency of the function element (3b).

13. Method for manufacturing a MEMS device (1100 -1300) according to any one of the preceding claims, comprising:
- providing (S101) a base element for building the device layer (3) comprising spring sections (3a) and a function element (3b) being spring-mounted by the spring sections (3a);
- applying a layer of piezo material at least on a section of the base element which will be the function element (3b) of the device layer (3), wherein the piezo material is applied on the base element such that alternating elastic deformations of the function element (3b) cause a piezo electric effect of the piezo material;
- structuring the layer of piezo material to form the at least one piezo damper (8); and
- structuring the base element to form the spring sections (3a) and the function element (3b) of the device layer (3), wherein the at least one piezo damper (8) is provided at the function element (3b).

14. Method according to claim 13, further comprising:
- determining locations of alternating elastic deformations of the function element (3b) resulting from an oscillation of the function element (3b) along and/or about at least one oscillation axis (X, Y), in particular from an oscillation of the function element (3b) in at least one transverse normal mode,
wherein the piezo material is structured to form the at least one piezo damper (8) at the function element (3b) at the respective determined locations of alternating elastic deformations of the function element (3b).

15. Method according to claim 13 or 14, further comprising:
- applying a conductive layer for building the electronic circuit (80, 80a - 80f); and
- structuring the applied conductive layer to form the electronic circuit (80, 80a - 80f) electrically connected with the at least one piezo damper (8),
wherein structuring the applied conductive layer comprises forming of at least one of resistance (R), capacitance (C) and/or inductance (L).
